# EUROPEAN PATENT APPLICATION

(11) **EP 2 793 329 A1**
(43) Date of publication of application: **22.10.2014**
(21) Application number: 12856468.9
(22) Date of filing: 27.11.2012
(51) Int. Cl.: H01S 5/022, G01J 3/10, G01J 3/45, H01S 5/024, H01S 5/183

(54) **OPTICAL SEMICONDUCTOR PACKAGE, MICHELSON INTERFEROMETER, AND FOURIER TRANSFORM SPECTROSCOPIC ANALYSIS APPARATUS**

(30) Priority: 06.12.2011 JP 2011266874
(71) Applicant: Konica Minolta, Inc., Tokyo 100-7015 (JP)
(72) Inventor: HIRAO, Yusuke, Tokyo 100-7015 (JP)
(74) Representative: HOFFMANN EITLE
(86) International application number: PCT/JP2012/080557
(87) International publication number: WO 2013/084746

(57) **Abstract**

An optical semiconductor package includes an optical semiconductor device, a temperature detection unit, and a temperature control unit (46) including a support member (46S), the optical semiconductor device and the temperature detection unit being arranged such that a temperature of a portion (P44) of a surface of the support member (46S) where the optical semiconductor device is arranged and a temperature of a portion (P45) of the surface of the support member (46S) where the temperature detection unit is arranged are substantially in thermal equilibrium with each other.

## Description

### TECHNICAL FIELD

The present invention relates to an optical semiconductor package, a Michelson interferometer, and a Fourier-transform spectroscopic analyzer, and more particularly to an optical semiconductor package including an optical semiconductor device that emits light whose wavelength varies depending on the temperature of the optical semiconductor device, a Michelson interferometer including the optical semiconductor package, and a Fourier-transform spectroscopic analyzer including the Michelson interferometer.

### BACKGROUND ART

A wavelength of light emitted from an optical semiconductor device such as an LED (Light Emitting Diode) or a semiconductor laser varies depending on the temperature of the optical semiconductor device itself. The temperature of the optical semiconductor device varies easily under the influence of the temperature of an environment in which the optical semiconductor device is arranged. Accordingly, there is a need for an optical semiconductor package in which the temperature of an optical semiconductor device can be controlled with high accuracy even if there is a great variation in environmental temperature.

Japanese Laid-Open Patent Publication No. 2003-142766 (PTD 1) discloses a laser package having an integrated temperature control device so as to control the temperature of a semiconductor laser with high accuracy. This publication states that, since the temperature of a photo-diode is regulated by an active temperature control device, temperature sensitive fluctuations in light intensity measurements made by the photo-diode can be substantially eliminated.

### CITATION LIST

### PATENT DOCUMENT

PTD 1: Japanese Laid-Open Patent Publication No. 2003-142766

### SUMMARY OF INVENTION

### TECHNICAL PROBLEM

An object of the present invention is to provide an optical semiconductor package in which the temperature of an optical semiconductor device can be controlled with higher accuracy, a Michelson interferometer including the optical semiconductor package, and a Fourier-transform spectroscopic analyzer including the Michelson interferometer.

### SOLUTION TO PROBLEM

An optical semiconductor package based on the present invention includes an optical semiconductor device that emits light whose wavelength varies depending on a temperature of the optical semiconductor device, a temperature detection unit arranged at a distance from the optical semiconductor device, and a temperature control unit including a support member, the support member having thermal conductivity and a surface on which the optical semiconductor device and the temperature detection unit are mounted, the temperature control unit heating or cooling the optical semiconductor device through the support member, the optical semiconductor device and the temperature detection unit being positioned such that a temperature of a portion on the surface of the support member where the optical semiconductor device is arranged and a temperature of a portion on the surface of the support member where the temperature detection unit is arranged are substantially in thermal equilibrium with each other, the temperature detection unit detecting the temperature of the portion on the surface of the support member where the temperature detection unit is arranged as a detection value, the temperature control unit controlling a temperature of the optical semiconductor device based on the detection value detected by the temperature detection unit, so that the temperature of the optical semiconductor device has a desired value.

Preferably, the support member has a portion formed as a plate, and the optical semiconductor device and the temperature detection unit are arranged on a surface of the portion formed as a plate of the support member. Preferably, the optical semiconductor device and the temperature detection unit are arranged such that they are not superimposed on a center position on the surface of the support member. Preferably, the optical semiconductor device and the temperature detection unit are arranged symmetrically with each other with respect to the center position on the surface of the support member.

Preferably, the surface of the support member has an outline in an oblong shape, and the optical semiconductor device and the temperature detection unit are arranged such that they are aligned along a longitudinal direction of the surface of the support member. Preferably, the optical semiconductor device consists of a vertical cavity surface emitting semiconductor laser (VCSEL) including a distributed bragg reflector (DBR). Preferably, the optical semiconductor package based on the present invention further includes a base member, and a cap member forming an internal space together with the base member, the internal space accommodating the optical semiconductor device, the temperature detection unit and the temperature control unit, in which the optical semiconductor device is arranged such that it is positioned on a central axis of the base member.

A Michelson interferometer based on the present invention includes the optical semiconductor package based on the present invention, a movable mirror, a stationary mirror, an optical path correcting device for correcting inclination of the stationary mirror, a beam splitter for splitting light emitted from the optical semiconductor device into a light beam traveling toward the stationary mirror and a light beam traveling toward the movable mirror, and combining light beams reflected off the stationary mirror and the movable mirror to emit interference light, and a reference detector for detecting the interference light, the optical path correcting device being driven such that the inclination of the stationary mirror attains a desired state, depending on intensity of the interference light detected by the reference detector.

A Fourier-transform spectroscopic analyzer based on the present invention includes the Michelson interferometer based on the present invention, the Michelson interferometer further including a measurement light detector for detecting measurement light applied to an analysis object, the Fourier-transform spectroscopic analyzer calculating a position of the movable mirror based on variation in the intensity of the interference light detected by the reference detector, and performing a Fourier transform using relation between the position of the movable mirror and an interferogram which is output from the measurement light detector, to output information about the analysis object.

### ADVANTAGEOUS EFFECTS OF INVENTION

According to the present invention, an optical semiconductor package in which the temperature of an optical semiconductor device can be controlled with higher accuracy, a Michelson interferometer including the optical semiconductor package, and a Fourier-transform spectroscopic analyzer including the Michelson interferometer can be obtained.

### BRIEF DESCRIPTION OF DRAWINGS

Fig. 1 schematically shows a Michelson interferometer including an optical semiconductor package in an embodiment, and a Fourier-transform spectroscopic analyzer including the Michelson interferometer.
Fig. 2 is a front view showing the configuration of a reference detector used in the Fourier-transform spectroscopic analyzer in the embodiment.
Fig. 3(A) shows temporal variation in intensity of part of interference light detected by the reference detector used in the Fourier-transform spectroscopic analyzer in the embodiment.
Fig. 3(B) shows temporal variation in intensity of the rest of the interference light detected by the reference detector used in the Fourier-transform spectroscopic analyzer in the embodiment.
Fig. 4 is a perspective view showing a reference light source as the optical semiconductor package in the embodiment.
Fig. 5 is a cross-sectional view showing the reference light source as the optical semiconductor package in the embodiment.
Fig. 6 is a cross-sectional view in a direction of arrows along line VI-VI in Fig. 5.
Fig. 7 is a perspective view showing a temperature control unit used in the reference light source as the optical semiconductor package in the embodiment.
Fig. 8 shows relation between a temperature distribution of a surface of a support substrate used in the optical semiconductor package in the embodiment, and positions of an optical semiconductor laser element and a temperature detection unit arranged on this support substrate, while the support substrate is heated.
Fig. 9 shows relation between a temperature distribution of the surface of the support substrate used in the optical semiconductor package in the embodiment, and the positions of the optical semiconductor laser element and the temperature detection unit arranged on this support substrate, while the support substrate is cooled.
Fig. 10 shows relation between a temperature distribution of the surface of the support substrate used in the optical semiconductor package in a comparative example, and the positions of the optical semiconductor laser element and the temperature detection unit arranged on this support substrate, while the support substrate is heated.
Fig. 11 shows relation between a temperature distribution of the surface of the support substrate used in the optical semiconductor package in the comparative example, and the positions of the optical semiconductor laser element and the temperature detection unit arranged on this support substrate, while the support substrate is cooled.

### DESCRIPTION OF EMBODIMENTS

An embodiment based on the present invention will be described below with reference to the drawings. When a reference is made to a number, an amount and the like in the description of the embodiment, the scope of the present invention is not necessarily limited to the number, the amount and the like unless otherwise specified. In the description of the embodiment, identical reference numerals denote the same or corresponding components, and redundant description may not be repeated.

### (Fourier-transform spectroscopic analyzer 100 · Michelson interferometer 10)

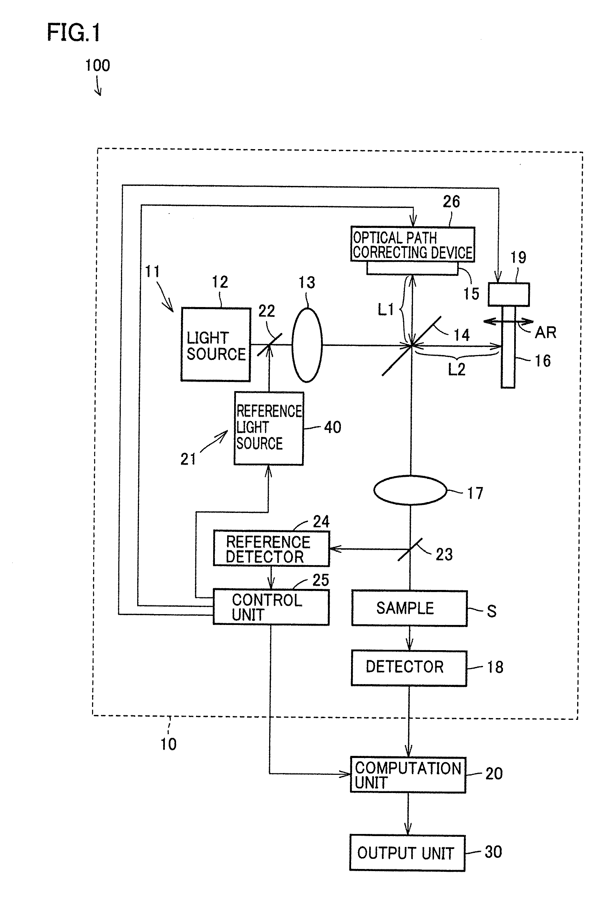

Referring to Fig. 1, a Fourier-transform spectroscopic analyzer 100 in an embodiment will be described. Fourier-transform spectroscopic analyzer 100 includes a Michelson interferometer 10, a computation unit 20, and an output unit 30. Michelson interferometer 10 includes a spectroscopic optical system 11, a reference optical system 21, and an optical path correcting device 26.

### (Spectroscopic optical system 11)

Spectroscopic optical system 11 includes a light source 12, a collimator optical system 13, a beam splitter 14 (light beam splitting means), a stationary mirror 15, a movable mirror 16, a condenser optical system 17, a detector 18 (measurement light detector), and a parallel movement mechanism 19.

Light source 12 consists of a light-emitting device such as a lamp having a color temperature of 2900K, and emits lamp light such as infrared light. The lamp light emitted from light source 12 is introduced into an optical path combining mirror 22 in reference optical system 21 (described later in detail), and combined with laser light emitted from a reference light source 40 (described later in detail) as an optical semiconductor package.

The combined light formed by the combination of the lamp light and the laser light is emitted from optical path combining mirror 22 and converted to parallel light by collimator optical system 13, before being introduced into beam splitter 14. Beam splitter 14 consists of a half mirror or the like, and can be designed to split light of any wavelength at any ratio.

Beam splitter 14 may consist of an optical thin film, a polarizing plate, or a composite thereof. The combined light (incident light) introduced into beam splitter 14 is split into two light beams.

One beam of the combined light (which includes the laser light) travels toward and is applied to stationary mirror 15. The combined light reflected off stationary mirror 15 (reflected light) passes through an optical path substantially identical to an optical path before the reflection, and is applied to beam splitter 14 again.

The other beam of the combined light (which includes the laser light) travels toward and is applied to movable mirror 16. The combined light reflected off movable mirror 16 (reflected light) passes through an optical path substantially identical to an optical path before the reflection, and is applied to beam splitter 14 again. The reflected light from stationary mirror 15 and the reflected light from movable mirror 16 are combined (superimposed) together by beam splitter 14.

When the other beam of the combined light is reflected off movable mirror 16, movable mirror 16 is reciprocating in a direction of an arrow AR while maintaining a parallel state by a parallel movement mechanism 19. The speed of movable mirror 16 is, for example, 100 m/sec. Due to the reciprocating movement of movable mirror 16, a difference in optical path length (hereinafter also referred to as an optical path difference) occurs between the reflected light from stationary mirror 15 and the reflected light from movable mirror 16.

Specifically, an optical path length of the combined light (which includes the laser light) that is split by beam splitter 14, reflected off stationary mirror 15 and applied to beam splitter 14 again is expressed as (L1 ×2). An optical path length of the combined light (which includes the laser light) that is split by beam splitter 14, reflected off movable mirror 16 and applied to beam splitter 14 again is expressed as (L2×2).

Accordingly, the optical path difference between the combined light reflected off stationary mirror 15 and the combined light reflected off movable mirror 16 is expressed as |(L2×2)-(L1 ×2)|. The reflected light from stationary mirror 15 and the reflected light from movable mirror 16 are combined by beam splitter 14 to form interference light.

The optical path difference |(L2×2)-(L1×2)| varies periodically depending on the position of movable mirror 16. The intensity of light as the interference light also varies continuously depending on the optical path difference. When the optical path difference is an integral multiple of a wavelength of the light applied to beam splitter 14 from collimator optical system 13, a maximum intensity of light as the interference light is obtained.

The interference light thus formed is applied to a sample S (analysis object) through condenser optical system 17 and an optical path splitting mirror 23. Specifically, the light beams combined by beam splitter 14 are emitted as the interference light from beam splitter 14, before being condensed by condenser optical system 17. The light condensed by condenser optical system 17 is introduced into optical path splitting mirror 23 in reference optical system 21 (described later in detail).

One beam of the interference light that has been split by optical path splitting mirror 23 is applied to sample S. The other beam of the interference light that has been split by optical path splitting mirror 23 is introduced into a reference detector 24 which will be described later. Detector 18 detects the combined light (which includes the laser light) that has been transmitted through sample S as an interference pattern (interferogram). This interference pattern is transmitted to computation unit 20 including a CPU (Central Processing Unit) and the like. Computation unit 20 converts the collected (sampled) interference pattern from analog form to digital form, and further subjects the converted data to a Fourier transform. In order to improve an S/N ratio to obtain spectral data with low noise, a plurality of measured interferograms may be aligned based on an amount of movement of movable mirror 16, and subjected to a Fourier transform to perform wavelength conversion.

From the Fourier transform, a spectral distribution (information about the analysis object) indicating the intensity of light per wave number (=1/wavelength) of the light (interference light) that has been transmitted through sample S is calculated. Data after the Fourier transform is output to another device or displayed on a display and the like through output unit 30. Based on this spectral distribution, the characteristics (e.g., material, structure, or ingredient amount) of sample S are analyzed.

### (Reference optical system 21)

Reference optical system 21 includes collimator optical system 13, beam splitter 14, stationary mirror 15, movable mirror 16, condenser optical system 17, reference light source 40 (optical semiconductor device), optical path combining mirror 22, optical path splitting mirror 23, reference detector 24, and a control unit 25. Collimator optical system 13, beam splitter 14, stationary mirror 15, movable mirror 16, and condenser optical system 17 are components common to both spectroscopic optical system 11 and reference optical system 21.

Reference light source 40 consists of a light-emitting device such as a semiconductor laser, and emits laser light such as red light (wavelength is between 300 nm and 1100 nm, for example). Reference light source 40 may consist of a vertical cavity surface emitting semiconductor laser (VCSEL) including a distributed bragg reflector (DBR).

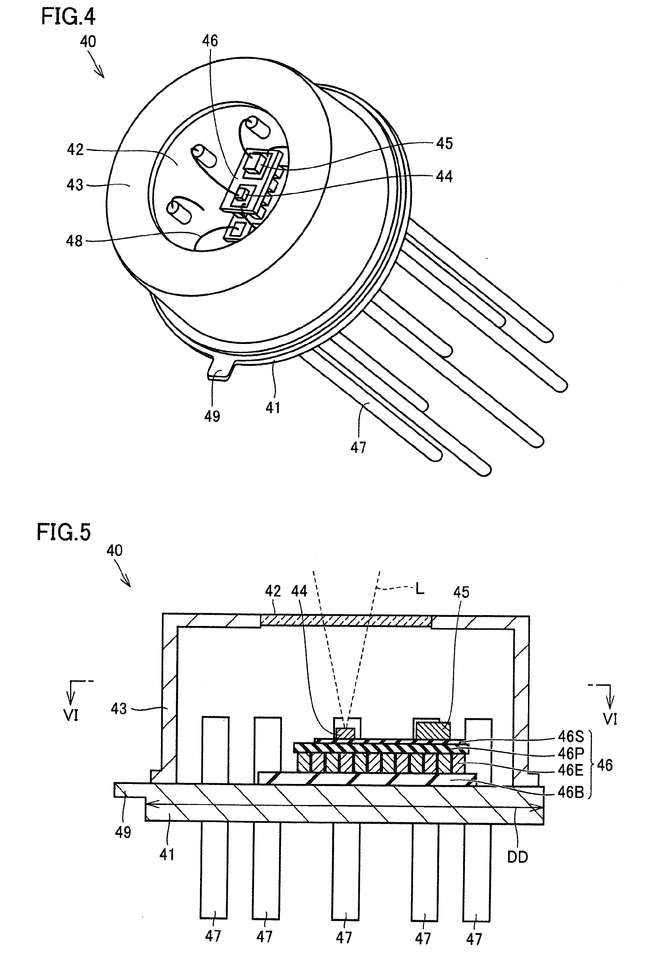

Reference light source 40 may consist of a wavelength-stabilized semiconductor laser utilizing diffraction grating, such as a VHG (Volume Holographic Grating) semiconductor laser or an FBG (Fiber Bragg Grating) semiconductor laser. A more detailed configuration of reference light source 40 will be described later with reference to Figs. 4 to 7.

As described above, the laser light emitted from reference light source 40 is introduced into optical path combining mirror 22. Optical path combining mirror 22 consists of a half mirror or the like. The lamp light from light source 12 is transmitted through optical path combining mirror 22. The laser light from reference light source 40 is reflected off optical path combining mirror 22.

The lamp light from light source 12 and the laser light from reference light source 40 are combined by optical path combining mirror 22 and emitted onto the same optical path from optical path combining mirror 22. The combined light emitted from optical path combining mirror 22 is converted to parallel light by collimator optical system 13, before being introduced into beam splitter 14 and split into two light beams.

As described above, one beam of the combined light is applied to stationary mirror 15, and applied to beam splitter 14 again as reflected light. The other beam of the combined light is applied to movable mirror 16, and applied to beam splitter 14 again as reflected light.

The reflected light from stationary mirror 15 and the reflected light from movable mirror 16 are combined by beam splitter 14 to form interference light. Stationary mirror 15 and movable mirror 16 may be configured such that they are movable relative to each other, or such that they are both movable, so long as the aforementioned difference |(L2×2)-(L1×2)| in optical path length can be attained.

As described above, the interference light thus formed is applied to sample S through condenser optical system 17 and optical path splitting mirror 23. Specifically, the light beams combined by beam splitter 14 are emitted as the interference light from beam splitter 14, before being condensed by condenser optical system 17.

The light condensed by condenser optical system 17 is introduced into optical path splitting mirror 23 in reference optical system 21. Optical path splitting mirror 23 consists of a half mirror or the like. One beam of the light that has been split by optical path splitting mirror 23 is applied to sample S. The other beam of the light that has been split by optical path splitting mirror 23 is introduced into reference detector 24.

The light emitted from light source 12 and introduced into optical path splitting mirror 23 through optical path combining mirror 22, collimator optical system 13, beam splitter 14, stationary mirror 15, movable mirror 16 and condenser optical system 17 is transmitted through optical path splitting mirror 23. As described above, this light (interference light) transmitted through optical path splitting mirror 23 is further transmitted through sample S before being detected by detector 18.

Meanwhile, the light emitted from reference light source 40 and introduced into optical path splitting mirror 23 through optical path combining mirror 22, collimator optical system 13, beam splitter 14, stationary mirror 15, movable mirror 16 and condenser optical system 17 is reflected off optical path splitting mirror 23. The reflected light (interference light) from optical path splitting mirror 23 is detected as an interference pattern by reference detector 24 consisting of a four-part divided sensor or the like.

The interference pattern of the interference light is transmitted to control unit 25 including a CPU and the like. Control unit 25 processes a signal based on the collected interference pattern, and calculates the intensity of the reflected light applied from optical path splitting mirror 23. Based on the intensity of the reflected light from optical path splitting mirror 23, control unit 25 can generate a signal indicating the timing of sampling in computation unit 20. The signal indicating the timing of sampling in computation unit 20 can be generated by known means.

Based on the intensity of the reflected light from optical path splitting mirror 23, control unit 25 can also calculate an inclination of the light between the two optical paths (relative inclination between the reflected light from stationary mirror 15 and the reflected light from movable mirror 16). The inclination of the light between the two optical paths can be calculated as follows, for example.

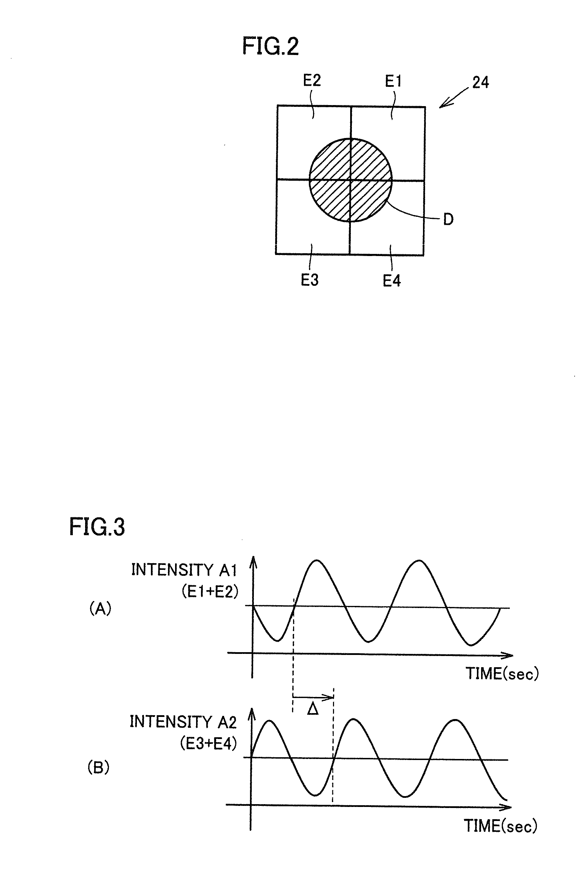

Referring to Fig. 2, reference detector 24 consisting of a four-part divided sensor has four light-receiving elements E1 to E4. Light-receiving elements E1 to E4 are arranged in a counterclockwise order and adjacent to one another. A region formed of light-receiving elements E1 to E4 is irradiated with the reflected light from optical path splitting mirror 23 (see Fig. 1). A center of the region formed of light-receiving elements E1 to E4 substantially matches a center of a spot D of the reflected light from optical path splitting mirror 23.

Each of light-receiving elements E1 to E4 detects the intensity of the reflected light applied to its own region from optical path splitting mirror 23. The intensity of the reflected light from optical path splitting mirror 23 is detected as a phase signal that varies with time, as shown in Figs. 3(A) and 3(B), for example.

A horizontal axis in each of Figs. 3(A) and 3(B) represents a lapse of time (unit: second). A vertical axis in Fig. 3(A) represents a sum of the light intensity detected by light-receiving element E1 and the light intensity detected by light-receiving element E2 as an intensity A1 (relative value). A vertical axis in Fig. 3(B) represents a sum of the light intensity detected by light-receiving element E3 and the light intensity detected by light-receiving element E4 as an intensity A2 (relative value).

As shown in Figs. 3(A) and 3(B), a phase difference Δ has occurred between intensity A1 and intensity A2. Based on phase difference Δ, the inclination of the light between the two optical paths (relative inclination between the reflected light from stationary mirror 15 and the reflected light from movable mirror 16) is calculated. Another phase difference Δ can be obtained based on another combination of light-receiving elements E1 to E4 (e.g., a combination of light-receiving elements E1, E4 and light-receiving elements E2, E3). Based on the aforementioned phase difference Δ and this phase difference Δ, a direction (vector) of the inclination of the light between the two optical paths can also be calculated.

### (Optical path correcting device 26)

Optical path correcting device 26 adjusts a posture of stationary mirror 15 (angle relative to beam splitter 14) based on a detection result from control unit 25 (relative inclination between the reflected light from stationary mirror 15 and the reflected light from movable mirror 16). This adjustment can correct the optical path of the reflected light from stationary mirror 15, to thereby eliminate (or reduce) the inclination of the light between the two optical paths. Since optical path correcting device 26 is provided within Michelson interferometer 10, the interference light can be generated with higher accuracy.

### (Reference light source 40)

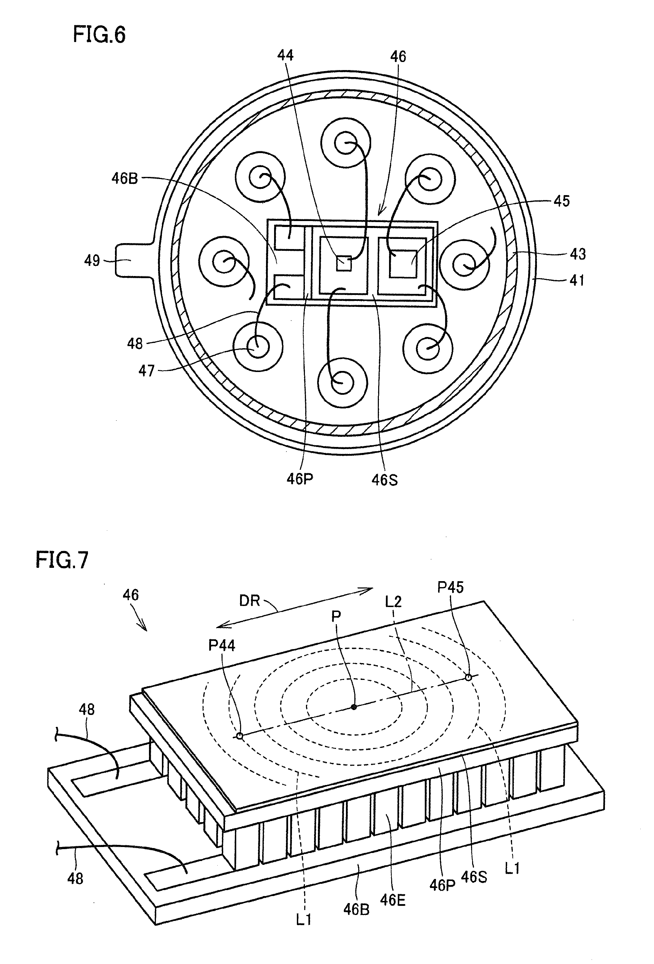

Referring to Figs. 4 to 7, reference light source 40 as an optical semiconductor package in this embodiment is described. Fig. 4 is a perspective view showing reference light source 40. Fig. 5 is a cross-sectional view showing reference light source 40. Fig. 6 is a cross-sectional view in a direction of arrows along line VI-VI in Fig. 5. Fig. 7 is a perspective view showing a temperature control unit 46 (active temperature control unit) used in reference light source 40.

As shown in Figs. 4 to 6, reference light source 40 is a TO (Transistor Outline)-5 optical semiconductor package. Reference light source 40 includes a base member 41 and a cap member 43 made of metal. Cap member 43 is provided with an emission window 42. Base member 41 and cap member 43 form a hollow space therein. A portion of an outer rim of base member 41 is provided with a projection 49 used for positioning and the like.

Provided in the internal space formed by base member 41 and cap member 43 are an optical semiconductor laser element 44 (optical semiconductor device), a temperature detection unit 45, and temperature control unit 46. Optical semiconductor laser element 44, temperature detection unit 45 and temperature control unit 46 are sealed in dry nitrogen within this internal space. This sealing prevents the occurrence of condensation and the like in temperature control unit 46.

A plurality of pin terminals 47 are provided to pass through the bottom of base member 41 from outside of base member 41 toward the internal space. The plurality of pin terminals 47 are electrically connected to optical semiconductor laser element 44, temperature detection unit 45, and temperature control unit 46 through conductive wires 48 (see Figs. 4 and 6), respectively.

Temperature detection unit 45 consists of a thermistor or the like having a resistance value of 10 kΩ, for example, and detects a temperature of a portion on a surface of support substrate 46S where temperature detection unit 45 is arranged as a detection value. Temperature control unit 46 controls the temperature of optical semiconductor laser element 44 based on the detection value detected by temperature detection unit 45, so that the temperature of optical semiconductor laser element 44 has a desired value. For example, temperature control unit 46 controls the temperature of optical semiconductor laser element 44 based on temperature variation of ±0.05°C, to thereby limit wavelength variation depending on the temperature to about 0.04 (nm·pp).

Temperature control unit 46 in this embodiment includes a base plate 46B fixed on base member 41, a plurality of Peltier elements 46E arranged in a matrix on base plate 46B, an insulative plate 46P having thermal conductivity and arranged on the plurality of Peltier elements 46E, and a support substrate 46S (support member) having thermal conductivity and arranged on insulative plate 46P.

Support substrate 46S in this embodiment is formed as a plate, and its surface has an outline in a rectangular shape (oblong shape). Optical semiconductor laser element 44 and temperature detection unit 45 are arranged at a distance from each other on support substrate 46S.

As described above, optical semiconductor laser element 44 in this embodiment consists of a vertical cavity surface emitting semiconductor laser (VCSEL) in a vertical single mode including a distributed bragg reflector (DBR). A wavelength of laser light L emitted from optical semiconductor laser element 44 (see Fig. 5) varies by about 0.4 (nm/k), for example, depending on the temperature of optical semiconductor laser element 44 itself.

AVCSEL has small light emission power of about 1 mW and generates a small amount of heat, as compared to other semiconductor laser elements. A plurality of VCSEL chips can be fabricated simultaneously on a wafer level. For example, four VCSELs can be integrated together to form optical semiconductor laser element 44. During operations such as wire bonding of attaching conductive wires 48, even if some of the four VCSELs are damaged, conductive wires 48 may be attached to other VCSEL chips and these other VCSEL chips may be used.

Optical semiconductor laser element 44 may be arranged such that it is positioned on a central axis of base member 41. The central axis of base member 41 as used herein refers to an axis which is perpendicular to a surface of base member 41, and which is positioned in the center of a disc-shaped portion DD of base member 41 (see Fig. 5). When collimating the light from reference light source 40 as an optical semiconductor package, or when coupling reference light source 40 to a fiber, a lens and the like can be readily positioned based on a reference position of the entire optical semiconductor laser package. In addition, efficiency of coupling to the fiber can be increased to increase laser light utilization efficiency, thus realizing a higher S/N ratio to form a detector having high accuracy.

In this embodiment, emission window 42 provided in cap member 43 is arranged to be perpendicular to an optical axis of laser light L emitted from optical semiconductor laser element 44. Advantageously, emission window 42 provided in cap member 43 may be arranged to be inclined relative to the optical axis of laser light L emitted from optical semiconductor laser element 44. Laser light L can be prevented from being reflected off emission window 42 to make light emission from optical semiconductor laser element 44 unstable. In addition, emission window 42 is preferably subjected to an AR (Anti Reflection) coating process in accordance with the wavelength of light emitted from the VCSEL.

Temperature control unit 46 is connected to a control device (not shown) provided outside of reference light source 40 through pin terminals 47. When temperature control unit 46 (Peltier elements 46E) is driven by this external control device, optical semiconductor laser element 44 is heated or cooled through insulative plate 46P and support substrate 46S. If Peltier elements 46E are used in temperature control unit 46, temperature control unit 46 can raise or lower the temperature of the surface of support substrate 46S by about 20°C to 30°C relative to an environmental temperature.

Fig. 7 is a perspective view showing temperature control unit 46 used in reference light source 40 as an optical semiconductor package in this embodiment. Referring to Fig. 7, when support substrate 46S is heated or cooled by Peltier elements 46E, the temperatures of the inside of support substrate 46S and of the surface of support substrate 46S are varied.

When the temperature of support substrate 46S is varied by heating and cooling means such as Peltier elements 46E, a temperature distribution such as indicated with dotted lines (isothermal lines) in Fig. 7 is formed on the surface of support substrate 46S. When support substrate 46S is heated, the temperature of a portion in the vicinity of a center position P of support substrate 46S becomes higher than the temperature of the other portions. When support substrate 46S is cooled, the temperature of the portion in the vicinity of center position P of support substrate 46S becomes lower than the temperature of the other portions. This temperature distribution becomes more pronounced with an increase in the difference between the temperature of the surface of support substrate 46S and the environmental temperature.

Optical semiconductor laser element 44 and temperature detection unit 45 in this embodiment are arranged on isothermal lines L1 having the same temperature, respectively, on the surface of support substrate 46S. In other words, the temperature of a position P44 on the surface of support substrate 46S where optical semiconductor laser element 44 (see Figs. 4 to 6) is arranged and the temperature of a position P45 on the surface of support substrate 46S where temperature detection unit 45 (see Figs. 4 to 6) is arranged are substantially in thermal equilibrium with each other.

Optical semiconductor laser element 44 and temperature detection unit 45 in this embodiment are arranged such that they do not include center position P of the surface of support substrate 46S, and are arranged such that they are positioned symmetrically with each other with respect to center position P of the surface of support substrate 46S.

Support substrate 46S in this embodiment has an outline in an oblong shape as described above, and optical semiconductor laser element 44 and temperature detection unit 45 are arranged such that they are aligned along a longitudinal direction (direction of an arrow DR) of the surface of support substrate 46S. A straight line L2 passing through optical semiconductor laser element 44 and temperature detection unit 45 is parallel to arrow DR.

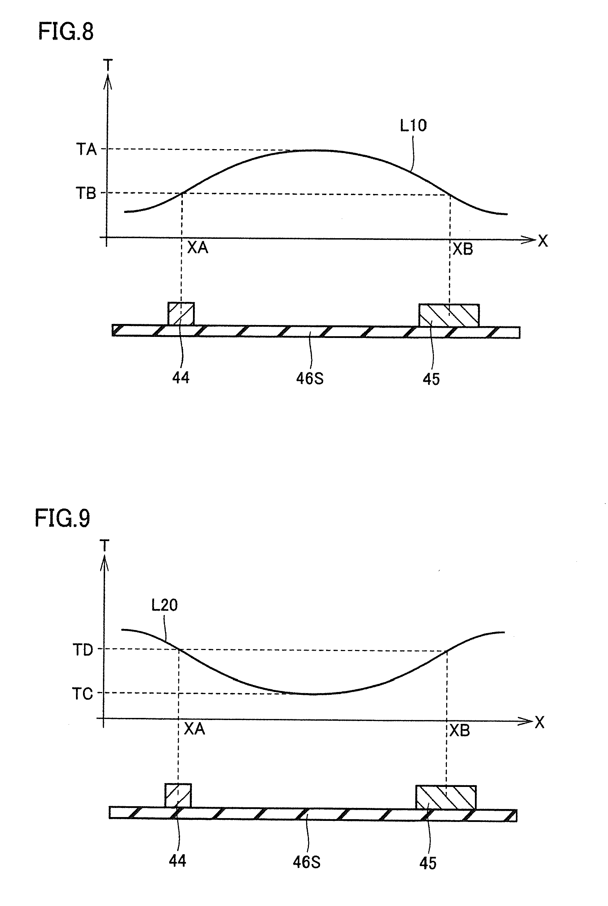

Fig. 8 shows relation between a distribution (L10) of a surface temperature (T) of support substrate 46S and positions (X) of optical semiconductor laser element 44 and temperature detection unit 45 arranged on support substrate 46S, while support substrate 46S is heated. As described above, when support substrate 46S is heated, temperature distribution L10 of support substrate 46S includes a temperature TA in the vicinity of the center and a temperature TB (TB<TA) in other portions XA and XB.

Fig. 9 shows relation between a distribution (L20) of the surface temperature (T) of support substrate 46S and the positions (X) of optical semiconductor laser element 44 and temperature detection unit 45 arranged on support substrate 46S, while support substrate 46S is cooled. As described above, when support substrate 46S is cooled, temperature distribution L20 of support substrate 46S includes a temperature TC in the vicinity of the center and a temperature TD (TC<TD) in the other portions XA and XB.

Referring to Figs. 8 and 9, optical semiconductor laser element 44 is arranged on position XA on support substrate 46S, and temperature detection unit 45 is arranged on position XB on support substrate 46S. Position XA corresponds to position P44 in Fig. 7. Position XB corresponds to position P45 in Fig. 7.

According to this arrangement, when temperature detection unit 45 detects a temperature of the portion on the surface of support substrate 46S where temperature detection unit 45 is arranged, a detection value obtained as a detection result is substantially equal to the value of a temperature of the portion on the surface of support substrate 46S where optical semiconductor laser element 44 is arranged.

Accordingly, when temperature control unit 46 controls the temperature of optical semiconductor laser element 44, temperature control unit 46 can control the temperature of optical semiconductor laser element 44 to have a desired value with high accuracy by controlling optical semiconductor laser element 44 based on the detection value detected by temperature detection unit 45. If a controlled temperature (target set temperature) of optical semiconductor laser element 44 is 25°C, for example, even if the environmental temperature varies from 25°C to 0°C or from 0°C to 60°C, a temperature of the portion on the surface of support substrate 46S where optical semiconductor laser element 44 is arranged can be detected with high accuracy, to thereby limit wavelength variation in the laser light to about 0.01 (nm).

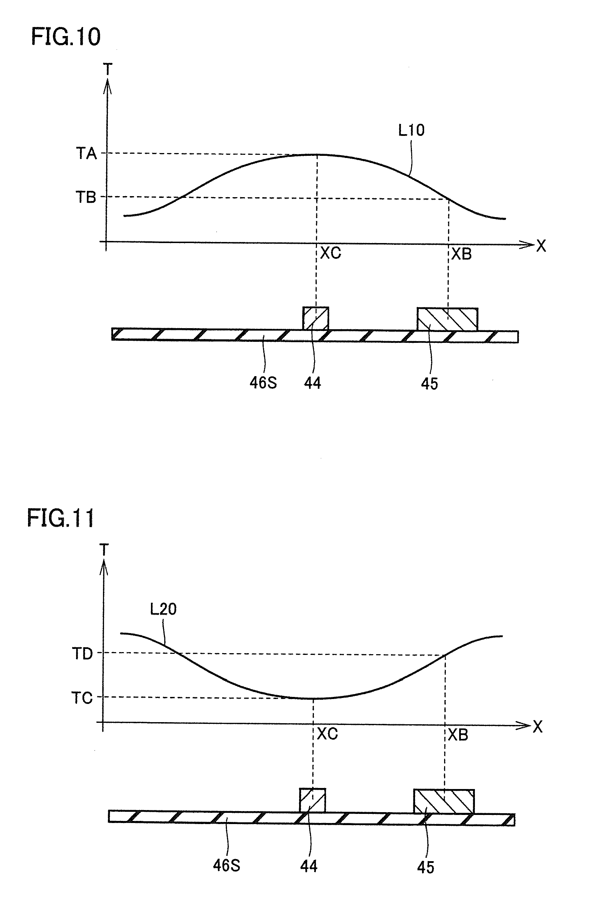

Referring to Figs. 10 and 11, as a comparative example, optical semiconductor laser element 44 is arranged in a position XC in the vicinity of the center of support substrate 46S. In this case, when temperature detection unit 45 detects a temperature of portion XB on the surface of support substrate 46S where temperature detection unit 45 is arranged, a detection value obtained as a detection result is different from the value of a temperature of portion XC on the surface of support substrate 46S where optical semiconductor laser element 44 is arranged. As a result, when temperature control unit 46 controls the temperature of optical semiconductor laser element 44, temperature control unit 46 cannot set the temperature of optical semiconductor laser element 44 to a desired value with high accuracy by controlling optical semiconductor laser element 44 based on the detection value detected by temperature detection unit 45.

In contrast, according to reference light source 40 as an optical semiconductor package in this embodiment, even if the temperature distribution of the surface of support substrate 46S varies with variation in the environmental temperature, the temperatures of the portions on the surface of support substrate 46S where optical semiconductor laser element 44 and temperature detection unit 45 are arranged vary equally. Even if the environmental temperature varies, the temperature of optical semiconductor laser element 44 can be set to any temperature with high accuracy based on the detection value from temperature detection unit 45, thereby obtaining highly stable laser light L.

Moreover, optical semiconductor laser element 44 and temperature detection unit 45 are arranged such that they do not include the center position of support substrate 46S which has the highest efficiency of heat exchange with Peltier elements 46E on the surface of support substrate 46S, and that they are positioned symmetrically with respect to the center position. Thus, even if the environmental temperature varies, the temperature of optical semiconductor laser element 44 can be set to any temperature with high accuracy based on the detection value from temperature detection unit 45, thereby obtaining more highly stable laser light L.

Considering an amount of heat generated by optical semiconductor laser element 44 itself, it is preferable to arrange optical semiconductor laser element 44 close to the center position on the surface of support substrate 46S. According to this arrangement, a value detected by temperature detection unit 45 can be brought closer to the temperature of the portion on the surface of support substrate 46S where optical semiconductor laser element 44 is provided.

Furthermore, the use of the VCSEL including a DBR as optical semiconductor laser element 44 can limit the wavelength of emitted light to any wavelength. In addition, since the configuration of the DBR itself has a temperature characteristic, the temperature of the DBR can be controlled together with the VCSEL, thereby obtaining a wavelength of more stable laser light.

When arranging optical semiconductor laser element 44 and temperature detection unit 45 on support substrate 46S, they are arranged along a long axis direction of support substrate 46S having an outline in an oblong shape. Thus, a surface area of the entire support substrate 46S can be reduced. An influx of heat from the surface of support substrate 46S can be reduced, thus making it easier to vary the surface temperature of support substrate 46S.

As described above, according to Michelson interferometer 10 including reference light source 40 as a semiconductor package in this embodiment, and the Fourier-transform spectroscopic analyzer including the Michelson interferometer, a result of analysis having a small deviation with respect to environmental temperature variation can be obtained.

Although the embodiment based on the present invention has been described above, the embodiment disclosed herein is illustrative and non-restrictive in every respect. The technical scope of the present invention is defined by the terms of the claims, and is intended to include any modifications within the scope and meaning equivalent to the terms of the claims.

### REFERENCE SIGNS LIST

10 Michelson interferometer; 11 spectroscopic optical system; 12 light source; 13 collimator optical system; 14 beam splitter; 15 stationary mirror; 16 movable mirror; 17 condenser optical system; 18 detector; 19 parallel movement mechanism; 20 computation unit; 21 reference optical system; 22 optical path combining mirror; 23 optical path splitting mirror; 24 reference detector; 25 control unit; 26 optical path correcting device; 30 output unit; 40 reference light source (optical semiconductor device); 41 base member; 42 emission window; 43 cap member; 44 optical semiconductor laser element; 45 temperature detection unit; 46 temperature control unit; 46B base plate; 46E Peltier element; 46P insulative plate; 46S support substrate; 47 pin terminal; 48 conductive wire; 49 projection; 100 Fourier-transform spectroscopic analyzer; A1, A2 intensity; D spot; DD, XA, XB, XC portion; AR, DR arrow; E1, E2, E3, E4 light-receiving element; L laser light; L1 isothermal line; L2 straight line; L10, L20 temperature distribution; P center position; P44, P45, XA, XB, XC position; S sample; TA, TB, TC, TD temperature.

## Claims

1. An optical semiconductor package comprising:
an optical semiconductor device that emits light whose wavelength varies depending on a temperature of the optical semiconductor device;
a temperature detection unit arranged at a distance from said optical semiconductor device; and
a temperature control unit including a support member, said support member having thermal conductivity and a surface on which said optical semiconductor device and said temperature detection unit are mounted, said temperature control unit heating or cooling said optical semiconductor device through said support member,
said optical semiconductor device and said temperature detection unit being arranged such that a temperature of a portion on said surface of said support member where said optical semiconductor device is arranged and a temperature of a portion on said surface of said support member where said temperature detection unit is arranged are substantially in thermal equilibrium with each other,
said temperature detection unit detecting the temperature of the portion on said surface of said support member where said temperature detection unit is arranged as a detection value,
said temperature control unit controlling a temperature of said optical semiconductor device based on said detection value detected by said temperature detection unit, so that the temperature of said optical semiconductor device has a desired value.

2. The optical semiconductor package according to claim 1, wherein
said support member has a portion formed as a plate, and
said optical semiconductor device and said temperature detection unit are arranged on a surface of said portion formed as a plate of said support member.

3. The optical semiconductor package according to claim 1 or 2, wherein
said optical semiconductor device and said temperature detection unit are arranged such that they do not include a center position on said surface of said support member.

4. The optical semiconductor package according to claim 3, wherein
said optical semiconductor device and said temperature detection unit are arranged symmetrically with each other with respect to said center position on said surface of said support member.

5. The optical semiconductor package according to any of claims 1 to 4, wherein
said surface of said support member has an outline in an oblong shape, and
said optical semiconductor device and said temperature detection unit are arranged such that they are aligned along a longitudinal direction of said surface of said support member.

6. The optical semiconductor package according to any of claims 1 to 5, wherein
said optical semiconductor device consists of a vertical cavity surface emitting semiconductor laser (VCSEL) including a distributed bragg reflector (DBR).

7. The optical semiconductor package according to any of claims 1 to 6, further comprising:
a base member; and
a cap member forming an internal space together with said base member, said internal space accommodating said optical semiconductor device, said temperature detection unit and said temperature control unit, wherein
said optical semiconductor device is arranged such that it is positioned on a central axis of said base member.

8. A Michelson interferometer comprising:
the optical semiconductor package according to any of claims 1 to 7;
a movable mirror;
a stationary mirror;
an optical path correcting device for correcting inclination of said stationary mirror;
light beam splitting means for splitting light emitted from said optical semiconductor device into a light beam traveling toward said stationary mirror and a light beam traveling toward said movable mirror, and combining light beams reflected off said stationary mirror and said movable mirror to emit interference light; and
a reference detector for detecting said interference light,
said optical path correcting device being driven such that the inclination of said stationary mirror attains a desired state, depending on intensity of said interference light detected by said reference detector.

9. A Fourier-transform spectroscopic analyzer comprising the Michelson interferometer according to claim 8,
said Michelson interferometer further including a measurement light detector for detecting measurement light applied to an analysis object,
said Fourier-transform spectroscopic analyzer calculating a position of said movable mirror based on variation in the intensity of said interference light detected by said reference detector, and performing a Fourier transform using relation between the position of said movable mirror and an interferogram which is output from said measurement light detector, to output information about said analysis object.
